# EUROPEAN PATENT SPECIFICATION

(11) **EP 4 621 336 B1**
(45) Date of publication and mention of the grant of the patent: **11.11.2026**
(21) Application number: 24172533.2
(22) Date of filing: 25.04.2024
(51) Int. Cl.: F28D 15/04

(54) **VAPOR CHAMBER STRUCTURE WITH PARTIALLY INCREASED PLATE THICKNESS**
DAMPFKAMMERSTRUKTUR MIT TEILWEISE VERGRÖSSERTER PLATTENDICKE
STRUCTURE DE CHAMBRE À VAPEUR AVEC ÉPAISSEUR DE PLAQUE PARTIELLEMENT AUGMENTÉE

(30) Priority: 19.03.2024 TW 113110185
(43) Date of publication of application: 24.09.2025
(73) Proprietor: Taiwan Microloops Corp., New Taipei City 23511 (TW)
(72) Inventor: LIN, Chun-Hung, 23511 New Taipei City (TW)
(74) Representative: 2K Patent Partnerschaft mbB

(56) References cited:
- US-A1- 2005 211 419
- US-A1- 2023 403 823
- US-B2- 7 658 223

## Description

### BACKGROUND

### Technical Field

The disclosure relates to a vapor chamber structure with a partially increased plate thickness.

### Related Art

In a related-art vapor chamber, there is a wick structure in both the upper plate and the lower plate, and the working fluid inside the vapor chamber generates a vapor phase change when heated, thereby transferring the heat from the heated lower plate rapidly to the upper plate through heat conduction, then the vaporized working fluid returns to a liquid state after condensation through the upper plate, and finally flows back into the lower plate from the wick structure.

US 2023/403823 A1 discloses a vapor chamber according to the preamble of claim 1 and describes a vapor chamber including: a first metal plate; a second metal plate having an outer edge portion joined to the first metal plate and forming a sealed space in which working fluid is enclosed, the sealed space being formed between the first metal plate and the second metal plate; and a wick stored inside the sealed space. The first metal plate has a through-hole communicating with the sealed space, and the vapor chamber further includes a metal block inserted into the through-hole and joined to the first metal plate to seal the through-hole, the metal block having an outer surface formed flat on a side opposite to a side facing the sealed space.

US 2005/211419 A1 discloses a heat dissipation module for providing good heat-dissipating efficiency. First and second cases correspond to each other, with a heat conducting structure connecting to an opening of the second case. The first and second cases and the heat conducting structure form a closed structure with a porous structure therein.

US 7 658 223 B2 discloses a refrigerant tank including a base plate made of cooper and a reinforcing frame made of stainless steel. A block made of copper extends through the reinforcing frame and has one face in contact with the base plate and an opposite face in contact with a heating body. Heat generated by the heating body is transferred through the cooper block and through the copper base plate to refrigerant inside the refrigerant tank. The stainless steel reinforcing frame provides strength to the refrigerant tank to allow the heating body to be pressed against the heating tank.

However, since related-art vapor chambers are often used in thinned electronic products, the upper plate and the lower plate are also relatively thinned in thickness, making it impossible to use a thicker plate to contact a heat source and store heat. Therefore, it needs to be improved.

In view of this, the inventors have devoted themselves to the above-mentioned prior art, researched intensively and cooperated with the application of science to try to solve the above-mentioned problems. Finally, the invention which is reasonable and effective to overcome the above drawbacks is provided.

### SUMMARY

An object of the disclosure is to provide a vapor chamber structure with a partially increased plate thickness, which uses junction to make the lower plate used for touching a heat source constituted by joining different thicknesses to partially thicken a part which is used to touch the heat source to improve the effect of heat transfer contact of vapor chamber.

To accomplish the above object, the invention provides a vapor chamber structure with a partially increased plate thickness as defined by claim 1. Accordingly, the vapor chamber structure includes an upper plate and a lower plate. The lower plate is superposed with the upper plate. A chamber is formed between the upper plate and the lower plate. Multiple support structures supported between the upper plate and the lower plate are disposed in the chamber. The lower plate includes a first lower plate and a second lower plate. The first lower plate has a first thickness. The second lower plate is disposed with a through hole for being inserted by the first lower plate to be closely connected. The through hole has a second thickness. The first thickness is greater than the second thickness. The vapor chamber structure of the invention is characterized in that the first lower plate comprises an inner surface, and the inner surface of the first lower plate is disposed with multiple support portions.

### BRIEF DESCRIPTION OF THE DRAWINGS

FIG. 1 is a cross-sectional schematic view of the internal structure of the first embodiment of the disclosure;
FIG. 2 is a cross-sectional exploded schematic view of the upper plate and the lower plate of the first embodiment of the disclosure;
FIG. 3 is a partially exploded schematic view of the upper plate and the lower plate of the first embodiment of the disclosure;
FIG. 4 is a partially cross-sectional schematic view of the first embodiment of the disclosure;
FIG. 5 is a partially cross-sectional schematic view of the second embodiment of the disclosure;
FIG. 6 is a partially cross-sectional schematic view of the third embodiment of the disclosure;
FIG. 7 is a partially cross-sectional schematic view of the fourth embodiment of the disclosure;
FIG. 8 is a partially cross-sectional schematic view of the fifth embodiment of the disclosure; and
FIG. 9 is a partially cross-sectional schematic view of the sixth embodiment of the disclosure.

### DETAILED DESCRIPTION

The technical contents of this disclosure will become apparent with the detailed description of embodiments accompanied with the illustration of related drawings as follows. It is intended that the embodiments and drawings disclosed herein are to be considered illustrative rather than restrictive.

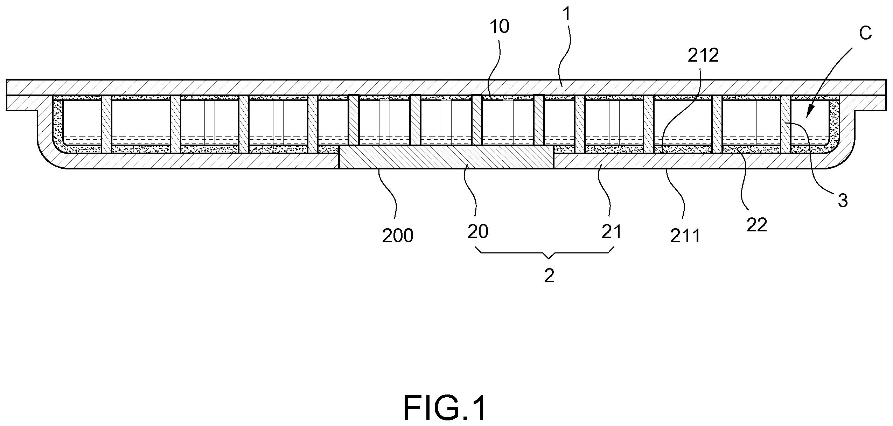

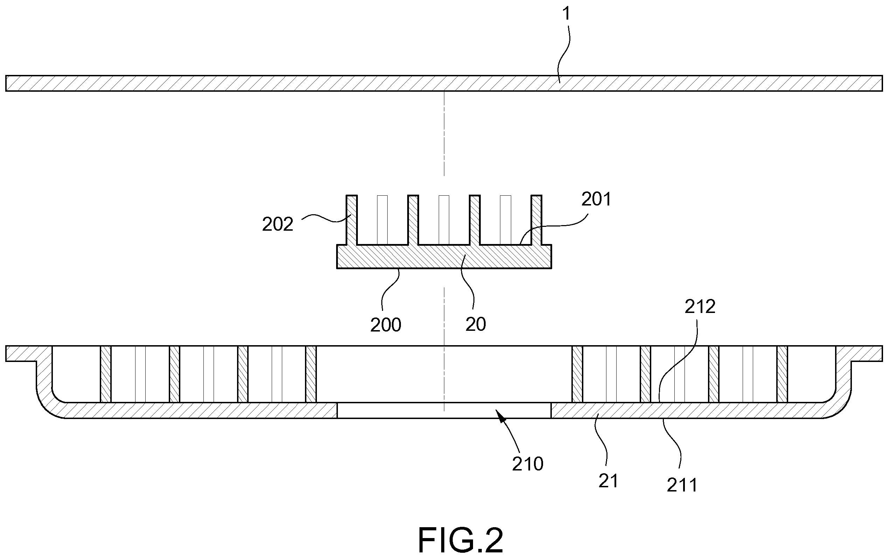

Please refer to FIGS. 1 and 2, which are a cross-sectional schematic view of the internal structure of the first embodiment of the disclosure and a cross-sectional exploded schematic view of the upper plate and the lower plate of the first embodiment of the disclosure, respectively. The disclosure provides a vapor chamber structure with a partially increased plate thickness, which includes an upper plate 1 and a lower plate 2.

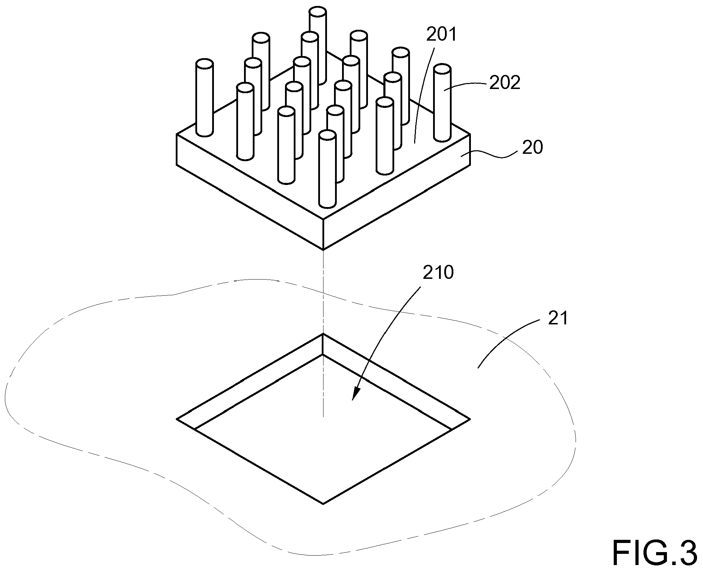

The upper plate 1 and the lower plate 2 may be made of a material with great thermal conductivity such as copper or aluminum. The lower plate 2 is composed of a first lower plate 20 and a second lower plate 21. Please refer to FIG. 3 together. The second lower plate 21 is disposed with a through hole 210. The through hole 210 matches with the contour of the first lower plate 20 to be formed so that the first lower plate 20 can be disposed on the through hole 210 by a manner of tight fit or tightening. And the second lower plate 21 and the first lower plate 20 are closely connected by a manner such as welding to constitute the lower plate 2.

Please refer to FIGS. 1 and 2. The upper plate 1 is covered on the lower plate 2 to form a chamber C between the upper plate 1 and the lower plate 2. In detail, the second lower plate 21 of the lower plate 2 may be formed with an indent toward the upper plate 1 to make the indent covered by the upper plate 2 and sealedly joined with the periphery of the second lower plate 21 to form the chamber C when covered with the upper plate 2. In addition, as shown in FIG. 1, a surface of the upper plate 1, which is opposite to the lower plate 2, may be disposed with an upper wick structure 10. The upper wick structure 10 is located in the chamber C and may be constituted by woven mesh, powder sintered or grooves formed on a surface of the upper plate 1.

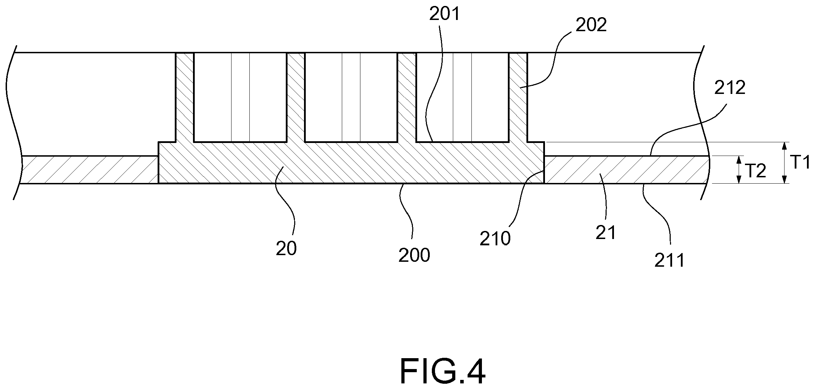

As shown in FIG. 4, the disclosure makes the first lower plate 20 of the lower plate 2 have a first thickness T1 and the second lower plate 21 of the lower plate 2 have a second thickness T2. The thickness of the through hole 210 disposed in the second lower plate 21 is substantially the same as the second thickness T2. The first thickness T1 is greater than the second thickness T2. As a result, an effect of partially thickening can be accomplished by the first thickness T1 of the first lower plate 21 so that the first lower plate 21 can be used to contact a heat source (not shown) and has functions of great heat storage and heat transfer.

Therefore, the vapor chamber structure with a partially increased plate thickness of the disclosure can be obtained by the above structure.

Please refer to FIGS. 1-4. In the shown embodiments of the disclosure, multiple support structures 3 supported between the upper plate 1 and the lower plate 2 may be disposed in the chamber C mentioned above. Furthermore, the first lower plate 20 of the lower plate 2 has a contact surface 200 and an inner surface 201 opposite to the contact surface 200. The inner surface 201 of the first lower plate 20 may also be disposed with multiple support portions 202. The support portions 202 may be the support structures 3 mentioned above (i.e., the support structures 3 may also be the support portions 202 on the inner surface 201 of the first lower plate 20) or the support structures 3 and the support portions 202 exist simultaneously. The support portions 202 may be integratedly formed with the first lower plate 20 such as extrusion forming. Furthermore, the second lower plate 21 has an outer surface 211 and an inner surface 212. The inner surface 212 may be disposed with a lower wick structure 22. The lower wick structure 22 is located in the chamber C and may be woven mesh, powder sintered or grooves formed on the inner surface 212. The contact surface 200 of the first lower plate 20 may be flush with the outer surface 211 of the second lower plate 21 to allow the inner surface 201 of the first lower plate 20 to stretch into the chamber C. Also, the support structures 3 mentioned above are supported between the upper plate 1 and the inner surface 212 of the second lower plate 21.

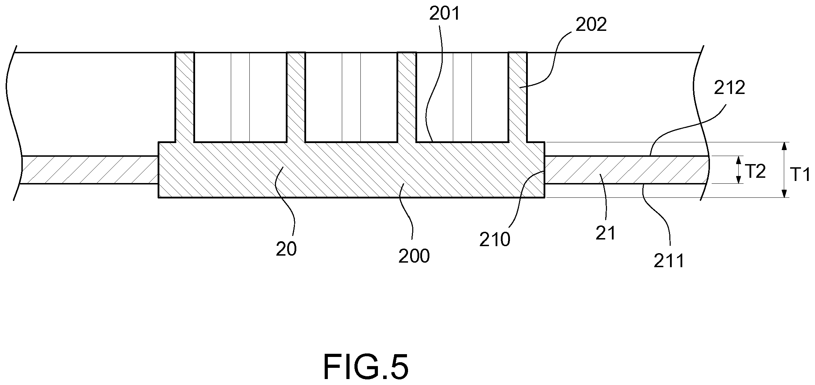

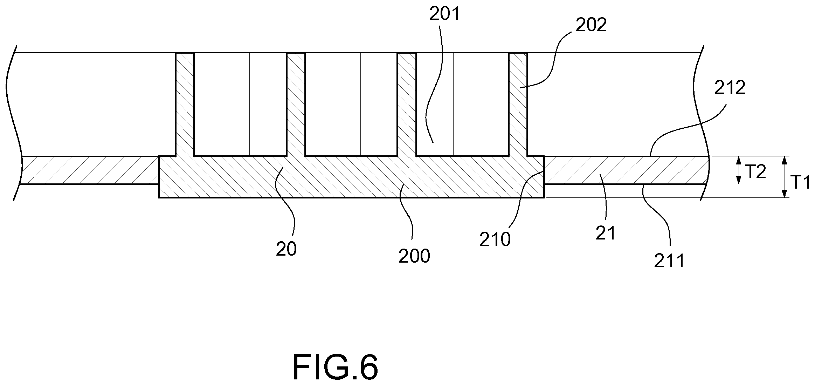

In addition, as shown in FIG. 5, the contact surface 200 and the inner surface 201 of the first lower plate 20 mentioned above may project from the outer surface 211 and the inner surface 212 of the second lower plate 21. That is, the first lower plate 20 is placed at a height position of the through hole 210. Of course, as shown in FIG. 6, the inner surface 201 of the first lower plate 20 may also be flush with the inner surface 212 of the second lower plate 21 to make the contact surface 200 of the first lower plate 20 project from the outer surface 211 of the second lower plate 21.

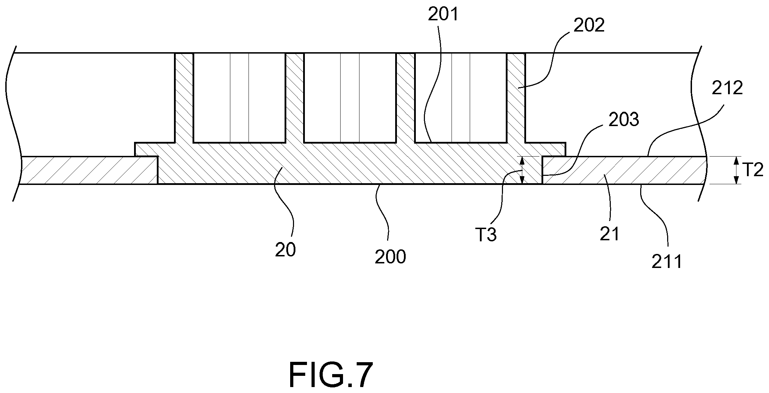

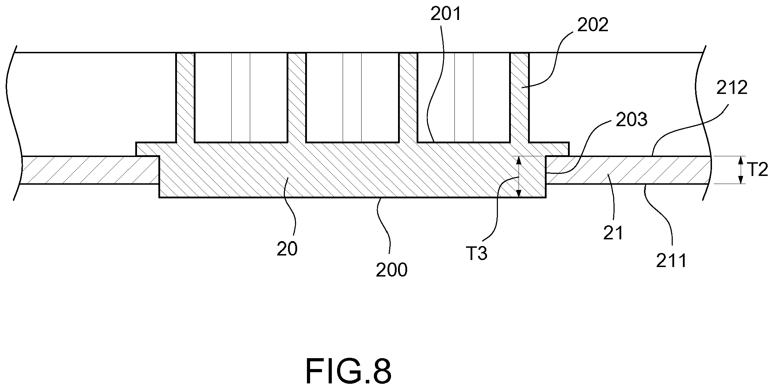

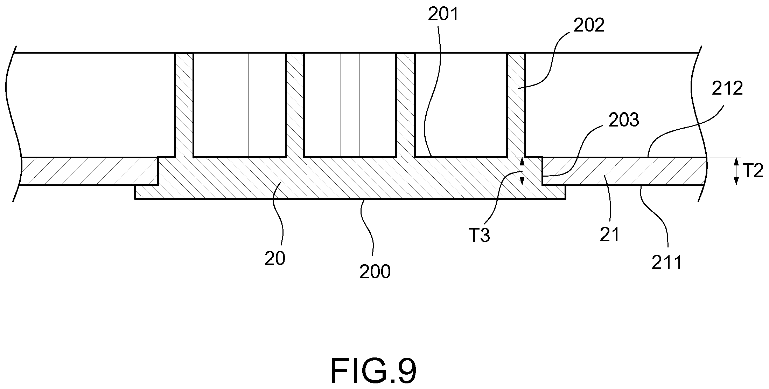

Moreover, as shown in FIGS. 7-9, furthermore, the disclosure may form a dented edge 203 on the first lower plate 20 mentioned above, which matches with the through hole 210 of the second lower plate 21. The dented edge 203 has a third thickness T3. The third thickness T3 is substantially greater than or equal to the second thickness T2, so that the first lower plate 20 can be expectably joined on the through hole 210 of the second lower plate 21. Identically, as shown in FIG. 7, when the dented edge 203 is substantially equal to the second thickness T2 and adjacent to the contact surface 200 of the first lower plate 20, the contact surface 200 of the first lower plate 20 is flush with the outer surface 211 of the second lower plate 21. As shown in FIG. 8, when the dented edge 203 is substantially greater than the second thickness T2, the contact surface 200 of the first lower plate 20 can project from the outer surface 211 of the second lower plate 21 or the inner surface 201 of the first lower plate 20 projects from the inner surface 212 of the second lower plate 21 (not shown). As shown in FIG. 9, when the dented edge 203 is substantially equal to the second thickness T2 and adjacent to the inner surface 201 of the first lower plate 20, the inner surface 201 of the first lower plate 20 is flush with the inner surface 212 of the second lower plate 21. Thus, variations of the above embodiments can still be implemented by the dented edge 203.

## Claims

1. A vapor chamber structure with a partially increased plate thickness, comprising:
an upper plate (1); and
a lower plate (2), superposed with the upper plate (1), a chamber (C) being formed between the upper plate (1) and the lower plate (2), and multiple support structures (3) supported between the upper plate (1) and the lower plate (2) being disposed in the chamber (C);
wherein the lower plate (2) comprises a first lower plate (20) and a second lower plate (21), the first lower plate (20) comprises a first thickness (T1), the second lower plate (21) is disposed with a through hole (210) for being inserted by the first lower plate (20) to be closely connected, the through hole (210) comprises a second thickness (T2), and the first thickness (T1) is greater than the second thickness (T2),
**characterized in that** the first lower plate (20) comprises an inner surface (201), and the inner surface (201) of the first lower plate (20) is disposed with multiple support portions (202).

2. The vapor chamber structure with a partially increased plate thickness of claim 1, wherein the upper plate (1) comprises a surface opposite to the lower plate (2), and the surface of the upper plate (1) is disposed with an upper wick structure (10).

3. The vapor chamber structure with a partially increased plate thickness of claim 1, wherein the second lower plate (21) of the lower plate (2) is formed with an indent toward the upper plate (1) to form the chamber (C).

4. The vapor chamber structure with a partially increased plate thickness of claim 1, wherein the first lower plate (20) is formed with a dented edge (203) which matches with the through hole (210), the dented edge (203) comprises a third thickness (T3), and the third thickness (T3) is substantially greater than or equal to the second thickness (T2).

5. The vapor chamber structure with a partially increased plate thickness of claim 1 or 4, wherein the second lower plate (21) and the first lower plate (20) are closely connected by welding.

6. The vapor chamber structure with a partially increased plate thickness of claim 1, wherein the first lower plate (20) comprises a contact surface (200), and the contact surface (200) projects from the outer surface (211) of the second lower plate (21) or is flush with the outer surface (211) of the second lower plate (21).

7. The vapor chamber structure with a partially increased plate thickness of claim 1, wherein the support portions (202) are integratedly formed with the first lower plate (20).

8. The vapor chamber structure with a partially increased plate thickness of claim 1, wherein the second lower plate (21) comprises an inner surface (212), and the support structures (3) are supported between the upper plate (1) and the inner surface (212) of the second lower plate (21).

9. The vapor chamber structure with a partially increased plate thickness of claim 8, wherein the inner surface (212) of the second lower plate (21) is disposed with a lower wick structure (22).

## Patentansprüche

1. Dampfkammerstruktur mit teilweise vergrößerter Plattendicke, umfassend:
eine obere Platte (1); und
eine untere Platte (2), die auf die obere Platte (1) aufgesetzt ist, wobei zwischen der oberen Platte (1) und der unteren Platte (2) eine Kammer (C) gebildet ist und mehrere Stützstrukturen (3), die zwischen der oberen Platte (1) und der unteren Platte (2) abgestützt sind, in der Kammer (C) angeordnet sind;
wobei die untere Platte (2) eine erste untere Platte (20) und eine zweite untere Platte (21) umfasst, wobei die erste untere Platte (20) eine erste Dicke (T1) aufweist, die zweite untere Platte (21) mit einem Durchgangsloch (210) versehen ist, in das die erste untere Platte (20) zum festen Verbinden eingeführt wird, wobei das Durchgangsloch (210) eine zweite Dicke (T2) aufweist und die erste Dicke (T1) größer als die zweite Dicke (T2) ist,
**dadurch gekennzeichnet, dass** die erste untere Platte (20) eine Innenfläche (201) aufweist und die Innenfläche (201) der ersten unteren Platte (20) mit mehreren Stützabschnitten (202) versehen ist.

2. Dampfkammerstruktur mit teilweise vergrößerter Plattendicke nach Anspruch 1, wobei die obere Platte (1) eine der unteren Platte (2) gegenüberliegende Oberfläche aufweist und die Oberfläche der oberen Platte (1) mit einer oberen Dochtstruktur (10) versehen ist.

3. Dampfkammerstruktur mit teilweise vergrößerter Plattendicke nach Anspruch 1, wobei die zweite untere Platte (21) der unteren Platte (2) mit einer zur oberen Platte (1) hin gerichteten Vertiefung ausgebildet ist, um die Kammer (C) zu bilden.

4. Dampfkammerstruktur mit einer teilweise vergrößerten Plattendicke nach Anspruch 1, wobei die erste untere Platte (20) mit einem eingezogenen Rand (203) ausgebildet ist, der mit dem Durchgangsloch (210) zusammenpasst, wobei der eingezogene Rand (203) eine dritte Dicke (T3) aufweist und die dritte Dicke (T3) im Wesentlichen größer oder gleich der zweiten Dicke (T2) ist.

5. Dampfkammerstruktur mit teilweise vergrößerter Plattendicke nach Anspruch 1 oder 4, wobei die zweite untere Platte (21) und die erste untere Platte (20) durch ein Schweißverfahren fest miteinander verbunden sind.

6. Dampfkammerstruktur mit einer teilweise vergrößerten Plattendicke nach Anspruch 1, wobei die erste untere Platte (20) eine Kontaktfläche (200) aufweist und die Kontaktfläche (200) von der Außenfläche (211) der zweiten unteren Platte (21) vorsteht oder bündig mit der Außenfläche (211) der zweiten unteren Platte (21) abschließt.

7. Dampfkammerstruktur mit teilweise vergrößerter Plattendicke nach Anspruch 1, wobei die Stützabschnitte (202) einstückig mit der ersten unteren Platte (20) ausgebildet sind.

8. Dampfkammerstruktur mit teilweise vergrößerter Plattendicke nach Anspruch 1, wobei die zweite untere Platte (21) eine Innenfläche (212) aufweist und die Stützstrukturen (3) zwischen der oberen Platte (1) und der Innenfläche (212) der zweiten unteren Platte (21) abgestützt sind.

9. Dampfkammerstruktur mit teilweise vergrößerter Plattendicke nach Anspruch 8, wobei die Innenfläche (212) der zweiten unteren Platte (21) mit einer unteren Dochtstruktur (22) versehen ist.

## Revendications

1. Structure de chambre à vapeur avec épaisseur de plaque partiellement augmentée, comprenant:
une plaque supérieure (1); et
une plaque inférieure (2) posée sur la plaque supérieure (1), une chambre (C) étant formée entre la plaque supérieure (1) et la plaque inférieure (2), et plusieurs structures de support (3), qui sont supportées entre la plaque supérieure (1) et la plaque inférieure (2), sont disposées dans la chambre (C);
la plaque inférieure (2) comprenant une première plaque inférieure (20) et une seconde plaque inférieure (21), la première plaque inférieure (20) présentant une première épaisseur (T1), la seconde plaque inférieure (21) étant pourvue d'un trou traversant (210) dans lequel la première plaque inférieure (20) est insérée pour une liaison fixe, le trou traversant (210) présentant une seconde épaisseur (T2) et la première épaisseur (T1) étant supérieure à la seconde épaisseur (T2),
**caractérisée en ce que** la première plaque inférieure (20) présente une surface intérieure (201) et la surface intérieure (201) de la première plaque inférieure (20) est pourvue de plusieurs portions de support (202).

2. Structure de chambre à vapeur avec épaisseur de plaque partiellement augmentée selon la revendication 1, dans laquelle la plaque supérieure (1) présente une surface opposée à la plaque inférieure (2) et la surface de la plaque supérieure (1) est pourvue d'une structure de mèche supérieure (10).

3. Structure de chambre à vapeur avec épaisseur de plaque partiellement augmentée selon la revendication 1, dans laquelle la seconde plaque inférieure (21) de la plaque inférieure (2) est pourvue d'un évidement orienté vers la plaque supérieure (1) afin de former la chambre (C).

4. Structure de chambre à vapeur avec épaisseur de plaque partiellement augmentée selon la revendication 1, dans laquelle la première plaque inférieure (20) est pourvue d'un bord rentré (203) qui s'adapte au trou traversant (210), le bord rentré (203) présentant une troisième épaisseur (T3) et ladite troisième épaisseur (T3) étant sensiblement supérieure ou égale à la seconde épaisseur (T2).

5. Structure de chambre à vapeur avec épaisseur de plaque partiellement augmentée selon la revendication 1 ou 4, dans laquelle la seconde plaque inférieure (21) et la première plaque inférieure (20) sont solidement assemblées l'une à l'autre par un procédé de soudage.

6. Structure de chambre à vapeur avec épaisseur de plaque partiellement augmentée selon la revendication 1, dans laquelle la première plaque inférieure (20) comporte une surface de contact (200) et ladite surface de contact (200) fait saillie par rapport à la surface extérieure (211) de la seconde plaque inférieure (21) ou affleure la surface extérieure (211) de la seconde plaque inférieure (21).

7. Structure de chambre à vapeur avec épaisseur de plaque partiellement augmentée selon la revendication 1, dans laquelle les portions de support (202) sont formées d'un seul tenant avec la première plaque inférieure (20).

8. Structure de chambre à vapeur avec épaisseur de plaque partiellement augmentée selon la revendication 1, dans laquelle la seconde plaque inférieure (21) présente une surface intérieure (212) et les structures de support (3) sont supportées entre la plaque supérieure (1) et la surface intérieure (212) de la seconde plaque inférieure (21).

9. Structure de chambre à vapeur avec épaisseur de plaque partiellement augmentée selon la revendication 8, dans laquelle la surface intérieure (212) de la seconde plaque inférieure (21) est pourvue d'une structure de mèche inférieure (22).
